# EUROPÄISCHE PATENTSCHRIFT

(11) **EP 0 608 726 B1**
(45) Veröffentlichungstag und Bekanntmachung des Hinweises auf die Patenterteilung: **26.03.1997**
(21) Anmeldenummer: 94100505.0
(22) Anmeldetag: 14.01.1994
(51) Int. Cl.: H05K 3/40

(54) **Verfahren zum Durchplattieren von Leiterfolien**
Process for plating through-connections between conducting foils
Procédé pour le placage de connexions traversantes entre des feuilles conductrices

(30) Priorität: 26.01.1993 CH 217/93
(43) Veröffentlichungstag der Anmeldung: 03.08.1994
(73) Patentinhaber: DYCONEX PATENTE AG, 6300 Zug (CH)
(72) Erfinder: Schmidt, Walter, CH-8050 Zürich (CH)
(74) Vertreter: Frei, Alexandra Sarah

(56) Entgegenhaltungen:
- EP-A- 0 533 198
- DE-U- 9 102 817
- GB-A- 1 126 370
- US-A- 3 953 924
- US-A- 4 769 309
- US-A- 4 991 285

## Beschreibung

Die Erfindung bezieht sich auf die Herstellung von Leiterfolien und betrifft ein Verfahren zum Herstellen von Durchplattierungen zwischen zwei- oder mehrschichtigen Leiterfolien.

In herkömmlichen Methoden der Leiterplattentechnik werden Platinenlöcher, welche primär zum elektrischen Verbinden verschiedener Leiterlagen verwendet werden, durch mechanisches Bohren erzeugt. Hierzu werden mehrschichtige Leiterplatten, bestehend aus mehreren Lagen von Metall/Nichtmetallschichten benutzt. Die Bohrlöcher werden dann mit elektrisch leitenden Materialien bspw. ausgefüllt, wodurch die Durchkontaktierungen gebildet werden. Mittels Strukturierung (Layout) der Leiterfolien, beispielsweise durch gezieltes Entfernen einzelner Oberflächenbereiche der äusseren Metallschichten dieser Leiterfolien, erhält man die fertige Schaltung. Ein Nachteil dieser Methode ist die durch das mechanische Bohren erzwungene Grösse der Bohrdurchmesser von bspw. 0,2mm. Derart grosse Bohrlöcher nehmen für viele Anwendungen rein flächenmässig zuviel Platz ein, sie verunmöglichen eine optimale, dichteste Leiterbelegung. Das mechanische Bohren von Durchkontaktierungen stellt eine technologische Grenze in der Leiterplattentechnik dar, da damit nur Bohrdurchmesser grösser als 0,2mm technisch und ökonomisch sinnvoll hergestellt werden können.

Eine nichtmechanische Methode zum Herstellen kleinerer Bohrlöcher besteht im galvanischen Durchplattieren ganzer vorgebohrter Leiterplatten, was aber bekanntermassen ein teurer und mit relativ grossem Ausschuss belasteter Prozess ist. Sobald Nasschemie zum Einsatz kommt, müssen umfangreiche Anlagen für Fabrikation und Entsorgung vorgesehen werden, was hohe Investitionskosten verursacht. Ausschüsse bei der Produktion verteuern das Produkt und eventuelle Kontaktausfälle im Bereich der verwendeten Plattierungshülse verursachen beträchtliche Folgekosten. Dies ist Grund genug, nach neuen Verfahren zu suchen.

Ein neuartiges Verfahren, das diese Probleme löst, ist bspw. in der Schweizer Patentanmeldung Nr: 01873/92-8 vom 15. Juni 1992 beschrieben. Darin wird ein nichtmechanisches und nicht(nass)galvanisches Verfahren zur simultanen Herstellung einer Vielzahl von betriebssicheren Durchplattierungen mehrlagiger Leiterfolien in verhältnismässig wenigen Arbeitsschritten beschrieben. Dieses Verfahren hat ausserdem den Vorteil, dass etablierte und damit bewährte Verarbeitungsschritte verwendet werden können, was die Herstellungssicherheit wesentlich verbessert. Es benötigt eine photochemische Strukturierung der Oberfläche und bedingt den Einsatz einer Plasma-Ätz-Anlage. Das Durchätzen der Leiterfolie ist, trotz der wesentlichen Vorteile, die diese Technik bietet, in letzter Konsequenz jedoch der geschwindigkeitsbestimmende Schritt der Herstellung. Dieses Verfahren hat somit den Nachteil, zeitaufwendiger als nötig und damit letztlich auch teurer zu sein.

Andere Lösungen für diese Probleme werden in den US-anmerikanischen Schriften 3'953'924 und 4'991'285 aufgezeigt. Die Schrift 3'953'924 beschreibt ein Verfahren, bei dem zwei identische Noppenstrukturen mittels mehrerer Schichten Dielektrika und durch Löcher im Dielektrika miteinander verpresst werden und über Noppen durch Löcher im Dielektrika elektrisch miteinander verbunden sind. Die Schrift 4'991'285 beschreibt ein Verfahren, bei dem elektrisch leitende Stangen durch mehrere strukturierte und nichtstrukturierte leitende und nichtleitende Schichten gedrückt werden und so verschiedene leitfähige Schichten elektrisch miteinander verbunden sind.

Der vorliegenden Erfindung liegt daher die Aufgabe zugrunde, ein Verfahren aufzuzeigen, um elektrische Verbindungen zwischen verschiedenen Leiterlagen von Metallfolien noch einfacher und kostengünstiger herzustellen. Diese Aufgabe wird durch eine spezielle Vorbereitung von Leiterfolien für die elektrisch leitende Schicht gelöst, derart, dass auf diese Leiterfolien in einem vorbereitenden Schritt Durchplattierungen aufgebracht werden, welche beim Laminieren der Metallfolien mit Nichtmetallfolien wie bspw. Haft- oder Klebefolien auf eine gegenüberliegende Leiterfolie oder Gegen-Metallfolie eine schnelle und sichere Herstellung mehrlagiger elektronischer Leiterfolien mit Durchplattierungen auch von Rolle zu Rolle ermöglicht. Die vorgearbeiteten Durchplattierungen auf der einen Leiterfolie drücken sich hierbei durch eine angrenzende Haftschicht einer Nichtmetallfolie und stellen so eine Verbindung zur nächsten, benachbarten Leiterfolie oder Gegen-Metallfolie her. Hierdurch wird einerseits das teure galvanische Durchplattieren und andererseits das zeitlich aufwendigere Durchätzen von Leiterfolien umgangen.

Nachfolgend wird eine Ausführungsform der Erfindung mit zwei weiteren Varianten anhand der nachfolgend aufgeführten Figuren im Detail erörtert.
- Fig.1: zeigt die einzelnen Schritte (1a-1h) des erfindungsgemässen Verfahrens in einer ersten, grundlegenden Ausführungsform.
- Fig.2: zeigt die einzelnen Schritte (2a-2h) des erfindungsgemässen Verfahrens in einer anderen Variante, bei der zum Herstellen von Durchplattierungen Ausnehmungen mit besonders geformten Begrenzungen benutzt werden.
- Fig.3: zeigt die einzelnen Schritte (3a-3d) des erfindungsgemässen Verfahrens in einer weiteren Variante, bei der eine Nachbehandlung der Durchplattierungen, hergestellt gemäss den Figuren 1 oder 2 erfolgt.

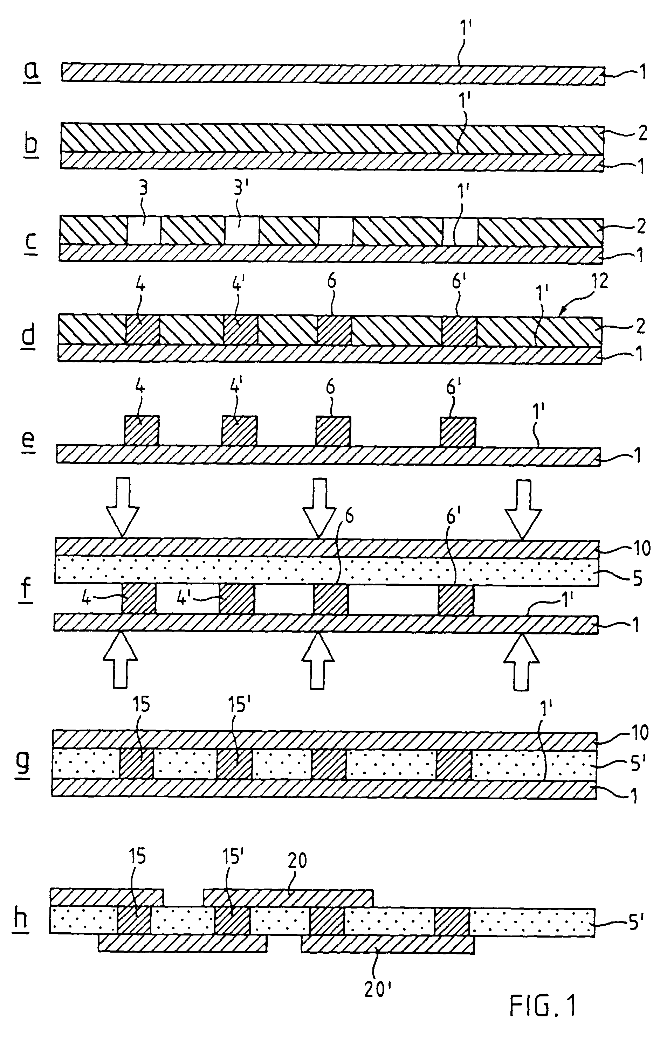

In **Figur 1** ist in schematischer Darstellung (Fig. 1a-1h) der Ablauf des erfindungsgemässen Verfahrens im Grundprinzip zu sehen.

Mit den Buchstaben a-c wird gezeigt, wie mit Hilfe eines an sich bekannten photochemischen Vorgehens in wenigen und wenig aufwendigen Arbeitsgängen ein feines, nahezu beliebiges, frei wählbares Muster von beliebig geformten Ausnehmungen 3,3' zur Formung von vorgearbeiteten Durchplattierungen hergestellt wird. Eine auf einer Seite 1' einer blanken Leiterfolie 1 aufgebrachte Schicht Photoresist 2 wird gemäss dem gewünschten Muster belichtet und anschliessend ausentwickelt. Nach Entfernen des umgesetzten Photoresists entstehen die Ausnehmungen 3,3' bspw. kreisrunde Fenster, mit sehr geringem Durchmesser unterhalb 100µm, welche bis zum Metall der Leiterfolie 1 hinab reichen. Als Metall wird vornehmlich Kupfer verwendet, bspw. Kupferfolien, wie sie zum Kaschieren von Leiterplatten verwendet werden. Die Ausnehmungen (3,3') müssen jedoch nicht kreisförmig sein, es können auch rechteckige Sacklöcher oder frei strukturierte Nuten sein, welche geradlinig oder gerippt oder geschwungen ausgeformt sind. Vorteilhafterweise wird mit diesen Vertiefungen das Muster der Durchplattierungen des Leiterplatten-Layouts erzeugt.

Figur 1d zeigt, wie anschliessend in einem galvanischen Plattierungsprozess Metall beispielsweise Kupfer, zonenweise in die Ausnehmungen 3,3' aufplattiert wird. Bevorzugterweise füllen diese vorbereiteten Durchplattierungen 4,4' die Ausnehmungen 3,3', wie abgebildet, vollständig aus, bei der gezeigten Variante weisen sie flache Begrenzungen 6,6' auf, derart, dass eine ebene Oberfläche der heterogenen Photoresist/Plattierung-Grenzflächen 12 entsteht. Dieser Arbeitsvorgang lässt sich durch geeignete Wahl der Plattierungsparameter kontrollieren. Natürlich können auch mehrere Schichten verschiedener Metalle nacheinander aufplattiert werden.

Im Schritt gemäss Figur 1e wird das restliche Photoresist 2 entfernt, sodass man eine blanke Leiterfolie 1 erhält, welche nunmehr auf mindestens einer Seite 1' die vorbereiteten Durchplattierungen 4,4' als Erhöhungen aufweist. Diese aufplattierten Erhöhungen sind die späteren Durchplattierungen in einer mehrlagigen Leiterfolie. Diese derart vorbereitete Leiterfolie 1 ist somit das Ausgangsmittel des erfindungsgemässen Verfahrens zur Herstellung von mehrschichtigen Leiterfolien.

In den Figuren 1f und 1g wird gezeigt, wie unter Verwendung einer Schicht Verbindungsmittel, bspw. einer Klebefolie 5 eine zweite Leiterfolie 10 auf Seite 1', der wie oben beschrieben, vorbereiteten Leiterfolie 1 aufgepresst wird. Das Verbindungsmittel oder die Klebefolie 5 liegt intermediär zwischen diesen beiden Leiterfolien 1 und 10 und kann aus handelsüblichen Klebemitteln, wie Epoxid-, Acryl-, Polyimidharzen bestehen, welche jedoch nicht vollständig ausgehärtet sind. In einer Heizpresse werden die beiden Leiterfolien 1 und 10 unter Druck und gegebenfalls unter erhöhter Temperatur zusammengepresst. Dieser Vorgang wird durch die dunklen Pfeile dargestellt. Erfindungsgemäss durchdringen hierbei die vorbereiteten Durchplattierungen 4,4' die intermediäre Klebefolie 5 und stellen die gewünschten elektrischen Verbindungen als Durchplattierungen 15,15' zwischen den Leiterfolien 1 und 10 sicher. Diese Durchplattierungen 15,15' werden beim Aushärten der Schicht Verbindungsmittel oder Klebefolie 5 in die ausgehärtete Klebefolie 5' stabilisiert und bilden somit Durchplattierungen 15,15' einer, in diesem Fall zweilagigen elektronischen Folienschaltung. Natürlich können mit diesem Verfahren auch Folienschaltungen mit mehr als zwei Lagen und auch aus verschiedenen Metallen hergestellt werden. Hierzu müssen die Schritte gemäss den Figuren 1a-1e und 1f-1g des Verfahrens dementsprechend oft wiederholt werden.

Es ist auch möglich, nicht nur eine der zu verklebenden Leiterfolien, sondern beide der zu verklebenden Leiterfolien, ein- oder beidseitig, mit vorgearbeiteten Durchplattierungen zu versehen, welche gemäss den Arbeitschritten nach Figur 1e aufgebracht werden. Hieraufhin kann auf eine oder auch auf beide dieser so vorbereiteten Leiterfolien eine Klebefolie auflaminiert werden, sodass die vorbereiteten Durchplattierungen der Leiterfolien die intermediären Klebefolien beim Pressen der Leiterfolien durchdringen und Durchplattierungen bilden.

Figur 1h zeigt die abschliessende Strukturierung der so gebildeten Kupferschichten. Durch das gezielte Entfernen einzelner Oberflächenbereiche der Leiterfolien 1 und 10 wird die Schaltung gemäss dem Layout der Leiterstruktur strukturiert. Dies geschieht mit an sich bekannten photochemischen Verfahren, wobei der Schaltungsentwurf mittels einer Photomaske übertragen wird und die Leitermuster 20,20' herausgeätzt werden.

Aus technischen Gründen werden bei diesen Schritten gemäss den Figuren 1a-1g möglichst dünne Leiterfolien 1,10 verwendet, derart, dass beispielsweise Unterätzungen minimal gehalten werden. Solch dünne Leiterfolien sind in der Regel schwierig zu verarbeiten, sodass sie oft mit einer mechanisch stabileren, dickeren, sogenannten Transfer- oder Trägerfolie kaschiert werden. Diese Kaschierung ist reversibel und zerstörungsfrei eliminierbar. Sie beeinflusst das Herstellen der Durchplattierungen nicht und kann schon nach dem Aufbringen der photosensitiven Schicht im Schritt gemäss Figur 1b oder erst nach dem Pressen der Leiterfolien 1,10 im Schritt gemäss Figur 1f abgelöst werden. Eine Hilfsmassnahme, wie die eben diskutierte Kaschierung ist für die Beschreibung des erfindungsgemässen Verfahrens nicht von zentraler Bedeutung und ist daher in den Figurenfolgen 1,2 und 3 nicht dargestellt.

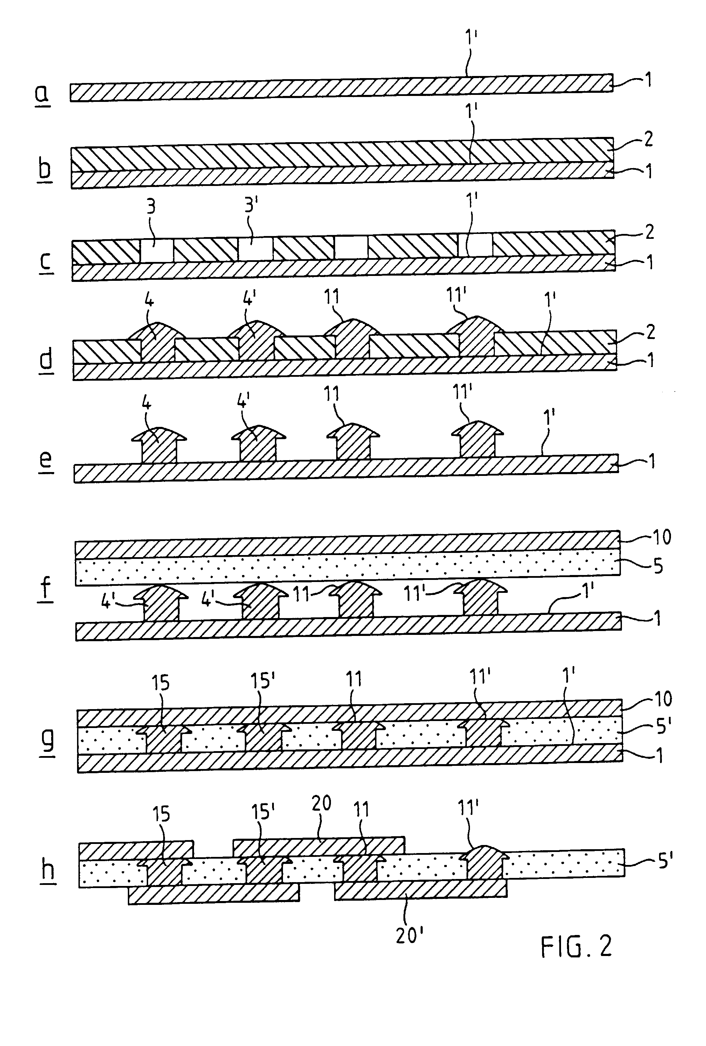

In **Figur 2** sind die einzelnen Schritte (Fig. 2a-h) des erfindungsgemässen Verfahrens in einer variierten Ausführungsform gezeigt, bei der vorbereitete Durchplattierungen mit besonders geformten Begrenzungen benutzt werden. Diese variierte Ausführungsform ist zweckmässig, um zu verhindern, dass Kleberückstände (von der intermediären Klebeschicht) zwischen den Durchplattierungen und der aufgesetzten Leiterfolie oder Gegen-Metallfolie 10 verbleiben und dadurch den elektrischen Kontakt zwischen den Leiterfolien 1 und 10 negativ beeinflussen.

In den Schritten gemäss den Figuren 2a-2c wird, analog zur Beschreibung von Figur 1, ein feines, beliebig wählbares Muster von speziell geformten Ausnehmungen 3,3' auf mindestens einer Seite 1' einer blanken Leiterfolie 1 mit bspw. einer auflamierten Schicht Photoresist 2 gebildet.

Im Schritt gemäss Figur 2d wird in einem galvanischen Plattierungsprozess Metall wiederum bevorzugt Kupfer, in die Ausnehmungen 3,3' aufplattiert. Im Unterschied zur ersten Ausführungsform in Figur 1 füllen diese vorbereiteten Durchplattierungen 4,4' die Ausnehmungen 3,3' diesmal nicht nur aus, sondern steht auf dem auflamierten Photoresist 2 über und bildet über die von Photoresist und den vorbereiteten Durchplattierungen gebildeten Grenzflächen 12 hinausragend, halbrundförmige oder flachrundförmige Begrenzungen 11,11' aus. Dieser Arbeitsvorgang lässt sich durch geeignete Wahl der Plattierungsparameter kontrollieren. Natürlich können auch hier mehrere Schichten, auch verschiedener Metalle, aufplattiert werden. Das restliche Photoresist wird dann vollständig entfernt, sodass eine blanke Leiterfolie 1 entsteht, welche die vorbereiteten Durchplattierungen 4,4' mit den halbrundförmigen oder flachrundförmigen Begrenzungen 11,11' als Erhöhungen aufweist.

In den Schritten gemäss den Figuren 2e-2h wird das erfindungsgemässe Verfahren, analog zur Beschreibung der Figur 1, beendet. Eine zweite Leiterfolie 10 wird unter Verwendung einer speziellen Schicht Verbindungsmittel oder Klebefolie 5 mit nicht vollständig ausgehärtetem Kleber auf die Seite 1' der ersten vorbereitete Leiterfolie 1 auflaminiert. In einer Heizpresse werden die beiden Leiterfolien 1 und 10 unter Druck und gegebenfalls unter erhöhter Temperatur zusammengepresst. Durch die spezielle Formgebung wird die Klebermasse besser verdrängt, als dies bei ebenen Flächen der Fall wäre, und so durchdringen die von den metallischen vorbereiteten Durchplattierungen 4,4' gebildeten Erhöhungen die intermediäre Klebefolie 5 leichter und stellen sichere elektrische Verbindungen 15,15' zwischen den Leiterfolien 1 und 10 her, welche ansonsten durch die ausgehärtete Klebefolie 5' getrennt sind. Diese Verbindungen sind aufgrund der halbrundförmigen oder flachrundförmigen Begrenzungen 11,11' besonders sicher und werden durch die ausgehärtete Klebefolie 5' stabilisiert und bilden somit Durchplattierungen 15,15' einer, in diesem Fall zweilagigen elektronischen Folienschaltung, während die dazwischenliegenden Zonen elektrisch isoliert bleiben. Natürlich können mit diesem Verfahren auch Folienschaltungen mit mehr als zwei Lagen und auch aus verschiedenen Metallen hergestellt werden. Hierzu müssen die Schritte gemäss den Figuren 2a-e und 2f-g des Verfahrens dementsprechend oft wiederholt werden. Abschliessend erfolgt die Strukturierung der so gebildeten Kupferschichten durch das gezielte Entfernen einzelner Oberflächenbereiche der Leiterfolien 1,10, sodass die Leitermuster 20,20' herausgeätzt werden.

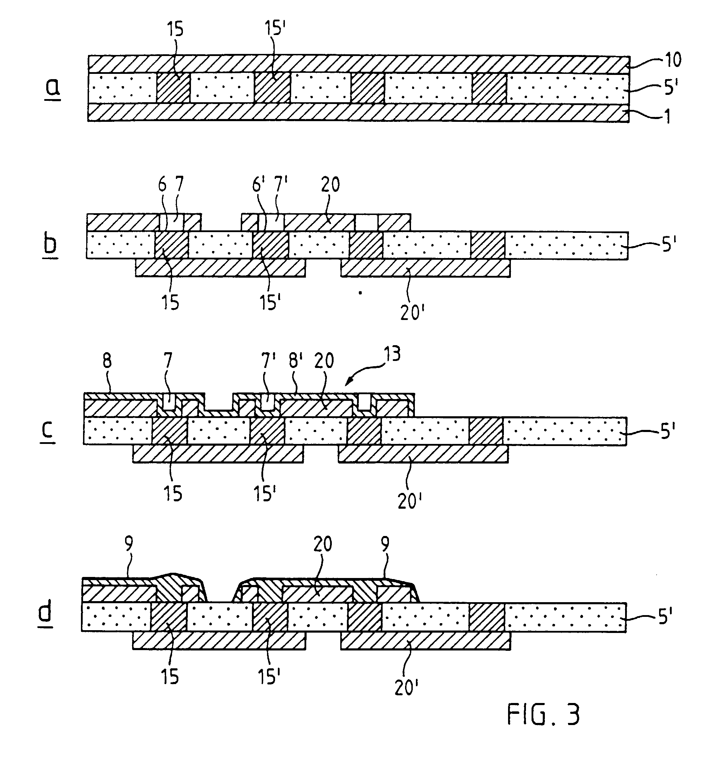

In **Figur 3** sind die einzelnen Schritte (Fig. 3a-d) des erfindungsgemässen Verfahrens in einer weiteren Variante gezeigt, bei der eine Nachbehandlung der Durchplattierungen 15,15' erfolgt. Diese zusätzliche Massnahme ist zweckmässig, um wie bei der Ausführungsform gemäss Figur 2 zu verhindern, dass beim Verbinden oder Zusammenkleben der Leiterfolien 1,10 Kleberückstände zwischen den vorbereiteten Durchplattierungen 4,4' und der aufgepressten gegenüberliegenden Leiterfolie 10 verbleiben und dadurch das Durchplattieren der Leiterfolien 1,10 erschwert oder mindert, mit dem Resultat einer schlechten elektrischen Verbindung.

Hierzu wird von einer, gemäss des in den Schritten gemäss den Figuren 1a-1g beschriebenen Vorgehens, einer hier zweilagigen elektronischen Folienschaltung ausgegangen. Eine solche Folienschaltung mit vorgearbeiteten Durchplattierungen (gemäss Figur 1g) ist in Figur 3a abgebildet.

Diese Folienschaltung wird nun im Schritt gemäss Fig. 3b derart behandelt, dass in einem photochemischen Verfahren der Schaltungsentwurf (Layout) mittels einer Photomaske auf die Leiterfolien 1 und 10 übertragen wird und die Leitermuster 20,20' herausgeätzt werden (analog zu den Schritten gemäss Buchstabe h der Figurenfolgen 1 und 2), wobei zusätzlich über den Durchplattierungen 15,15' Sacklöcher 7,7' geschaffen werden, welche Zugang zu den flachen Begrenzungen 6,6' der Durchplattierungen 15,15' ermöglichen. Durch Sandstrahlen oder gezieltes leichtes Plasma-Ätzen können eventuell vorhandene Kleberückstände von den Begrenzungen 6,6' der Durchplattierungen 15,15' entfernt werden.

Im Schritt gemäss Figur 3c werden anschliessend chemisch eine oder mehrere Metallschichten 8,8' gezielt auf die Leiterfolie/Plattierung-Grenzfläche aufgetragen. Die Metallfolie/Plattierungen-Grenzflächen 13 können hierbei vollständig oder teilweise bedeckt werden. Als Metall kann beispielsweise Nickel, Gold, Zinn etc. benutzt werden. Die vormaligen Sacklöcher 7,7' können hierbei weiterhin bestehen bleiben oder im Durchmesser verkleinert werden oder ganz verschlossen werden. Auf diese Weise kann an bestimmten Stellen oder generell in Form einer Zusatzbehandlung die elektrische Leitfähigkeit der Durchplattierungen 15,15' verbessert werden.

Die abschliessende Behandlung der Leiterfolien in einem Schritt gemäss Figur 3d erfolgt beispielsweise durch Verzinnungen 9 der Oberfläche, wobei mittels Heissluft-Verzinnens die Stärkung und Stabilisierung der Durchplattierungen 15,15' der in diesem Anwendungsbeispiel zweilagigen elektronischen Folienschaltung erfolgt. Andere mögliche Arbeitsschritte, welche zum selben Ergebnis führen, können beispielsweise das Eindrücken leitfähiger Lötpasten oder leitfähigen Kunststoffs in die Sacklöcher 7,7' sein, oder einfach das Aufschmelzen derselben.

Natürlich lassen sich durch Wiederholung der Schritte gemäss den Figuren 3a-3d auch drei-, vier- und mehrlagige Folienschaltungen schaffen. Hierzu kann beispielsweise eine Folienschaltung nach Beendigung des Schritts gemäss Figur 3d mit einer weiteren Klebefolie laminiert werden, sodass sie danach im Arbeitsschritt f von Figur 1 oder 2 als Leiterfolie 10 wieder in das Verfahren integriert werden kann. Hierbei bestehen beliebig viele Variationsmöglichkeiten, die der Fachmann, in Kenntnis der Erfindung, anwenden kann.

Das erfindungsgemässe Verfahren zum Herstellen von Durchkontaktierungen zwischen dünnen Leiterfolien lässt sich gut in einem kontinuierlichen Prozess einer Rolle-zu-Rolle Verarbeitung anwenden. Die Metallfolien selbst, als auch die Nichtmetallfolien wie die aufzulaminierenden Photoresistfolien oder die aufzulaminierenden Klebefolien, liegen in Rollenform vor und alle beschriebenen Arbeitsschritte lassen sich in Fliessbandweise durchführen. Dies ist ein bedeutender Fortschritt gegenüber der konventionellen Leiterplatten- oder Leiterfolientechnik; Totzeiten und Leerplätze, bedingt durch den Transfer einzelner Leiterplatten oder Leiterfolien, fallen bei der oben diskutierten Methode weg.

## Patentansprüche

1. Verfahren zum Herstellen von miteinander verbundenen Leiterfolien (1,10) für zwei- und mehrschichtige Leiterplatten, wobei eine erste Leiterfolie (1) auf mindestens einer Seite (1') zonenweise aufplattiert wird, um eine gewünschte Anzahl von vorgearbeiteten Durchplattierungen (4,4') zu erzielen, **dadurch gekennzeichnet,** dass eine andere Leiterfolie (10), welche keine vorgearbeiteten Durchplattierungen (4,4') aufweist, mittels eines Verbindungsmittels (5) so auf die Leiterfolie (1) mit den vorgearbeiteten Durchplattierungen (4,4') aufgebracht werden kann, dass die Leiterfolien über die vorgearbeiteten Durchplattierungen (4,4') der ersten Leiterfolie (1) elektrisch verbunden sind und das Verbindungsmittel (5) die Zonen zwischen den vorgearbeiteten Durchplattierungen (4,4') elektrisch isoliert.

2. Verfahren zum Herstellen von miteinander verbundenen Leiterfolien (1,10) gemäss Anspruch 1, wobei auf die erste Leiterfolie (1) eine Schicht Photresist (2) auflaminiert wird und photochemisch ein frei wählbares Muster von Ausnehmungen (3,3') im Photoresist (2) belichtet und entwickelt wird, **dadurch gekennzeichnet**, dass vorgearbeitete Durchplattierungen (4,4') derart in die Ausnehmungen (3,3') der Leiterfolien (1) aufplattiert werden, dass die vorgearbeiteten Durchplattierungen (4,4') die Ausnehmungen (3,3') vollständig ausfüllen und über das Photoresist (2) überstehen und halbrundförmige oder flachrundförmige Begrenzungen (11,11') besitzen, derart, dass eine unebene Oberfläche der heterogenen Photoresist/Plattierung-Grenzfläche (12) entsteht.

3. Verfahren zum Herstellen von miteinander verbundenen Leiterfolien (1,10) nach einem der Ansprüche 1 oder 2, **dadurch gekennzeichnet**, dass die zu verarbeitenden Metallfolien (1,10) durch Transfer- oder Trägerfolien kaschiert werden.

4. Leiterfolie (1), hergestellt unter Verwendung des Verfahrens nach Anspruch 2, **dadurch gekennzeichnet,** dass sie aus einem elektrisch leitenden Material besteht und Zonen mit vorgearbeiteten Durchplattierungen (4,4') aufweist, welche aus der Seite (1') der Leiterfolie (1) vorstehen.

5. Verfahren zum Herstellen von Leiterplatten mit zwei oder mehr elektrisch leitenden, durchkontaktierten Schichten (1,10), unter Anwendung des Verfahrens gemäss Anspruch 1, unter Verwendung einer ersten Leiterfolie (1), welche auf mindestens einer Seite (1') zonenweise aufplattiert ist und eine gewünschte Anzahl von vorgearbeiteten Durchplattierungen (4,4') aufweist, **dadurch gekennzeichnet**, dass eine andere Leiterfolie (10), welche keine vorgearbeitete Durchplattierungen aufweist, mittels eines Verbindungsmittels (5) so auf die erste Leiterfolie (1) mit den vorgearbeiteten Durchplattierungen (4,4') aufgebracht wird, dass die Leiterfolien über diese vorbereiteten Durchplattierungen (4,4') elektrisch verbunden und die übrigen Zonen durch das dazwischenliegende Verbindungsmittel (5) elektrisch isoliert sind, wobei die vorbereiteten Durchplattierungen (4,4') beim Zusammenpressen der Leiterfolien (1,10) das Verbindungsmittel (5) durchdringen und die Leiterfolien (1,10) an vorgesehenen Stellen die Durchplattierungen (15,15') bilden.

6. Verfahren zum Herstellen von Leiterplatten gemäss Anspruch 5, **dadurch gekennzeichnet**, dass in einem photochemischen Verfahren nachträglich Sacklöcher (7,7') in die Leiterfolien (1,10) belichtet und ausentwickelt werden, derart dass Zugang zu den flachen Begrenzungen (6,6') der Durchplattierungen (15,15') geschaffen wird, dass durch Sandstrahlen oder Plasma-Ätzen vorhandene Kleberückstände von den Begrenzungen (6,6') der Durchplattierungen (15,15') entfernt werden, dass chemisch eine oder mehrere Metallschichten (8,8') gezielt auf die Metallfolien/Plattierungen-Grenzfläche (13) aufgetragen werden, und dass die nachträglich geschaffenen Sacklöcher (7,7') durch Heissluft-Verzinnungen (9) oder das Eindrücken leitfähiger Lötpasten oder leitfähigen Kunststoffs oder einfach durch Aufschmelzen dieser Sacklöcher (7,7') ausgefüllt werden.

7. Verfahren zum Herstellen von Leiterplatten nach einem der Ansprüche 5 oder 6, **dadurch gekennzeichnet**, dass als Leiterfolien (1,10) Metallfolien aus Kupfer verwendet werden.

8. Verfahren zum Herstellen von Leiterplatten nach einem der Ansprüche 5 bis 7, **dadurch gekennzeichnet,** dass das Verfahren in einem kontinuierlichen Prozess in Rolle-zu-Rolle Verarbeitung der zu verarbeitenden Metallschichten (1,10) und Nichtmetallschichten (2,5) durch Zusammenführen auf eine Rolle durchgeführt wird.

9. Leiterplatte mit zwei oder mehr elektrisch leitenden, durchkontaktierten Schichten (1,10), hergestellt unter Anwendung des Verfahrens nach einem der Ansprüche 1 bis 3 und 5 bis 8, **dadurch gekennzeichnet**, dass die Leiterfolien (1,10) durch eine intermediäre Schicht, eines elektrisch nichtleitenden Verbindungsmittels (5) getrennt sind, dass mindestens eine Leiterfolie (1) auf mindestens einer Seite (1') zonenweise aufplattiert ist, dass die andere Leiterfolie (10) so auf die Leiterfolie (1) mit den vorgearbeiteten Durchplattierungen (4,4') aufgebracht ist, dass die Leiterfolien (1,10) über diese vorgearbeiteten Durchplattierungen (4,4') verbunden, wobei die vorgearbeiteten Durchplattierungen (4,4') die Schicht Verbindungsmittel (5) durchdringen, wodurch zwei Leiterfolien (1,10) an vorgesehenen Stellen (15,15') elektrisch verbunden sind.

## Claims

1. Method for the manufacture of interconnected conductor foils (1, 10) for two and multiple layer circuit boards, a first conductor foil (1) being zonally plated onto at least one side (1') in order to obtain a desired number of preworked interfacial connections (4, 4'), characterized in that another conductor foil (10), which has no preworked interfacial connections (4, 4'), can be applied by means of a connecting medium (5) to the conductor foil (1) with the preworked interfacial connections (4, 4') in such a way that the conductor foils are electrically connected by means of the preworked interfacial connections (4, 4') of the first conductor foil (1) and the connecting medium (5) electrically insulates the zones between the preworked interfacial connections (4, 4').

2. Method for the manufacture of interconnected conductor foils (1, 10) according to claim 1, in which onto the first conductor foil (1) is laminated a photoresist coating (2) and photochemically a freely selectable pattern of recesses (3, 3') in the photoresist (3) is exposed and developed, characterized in that preworked interfacial connections (4, 4') are so plated into the recesses (3, 3') of the conductor foils that the preworked interfacial connections (4, 4') completely fill the recesses (3, 3') and project above the photoresist (2) and have semicircular or oval boundaries (11, 11'), so that there is a non-planar surface of the heterogeneous photoresist/plating interface (12).

3. Method for the manufacture of interconnected conductor foils (1, 10) according to one of the claims 1 or 2, characterized in that the metal foils (1, 10) to be processed are coated by transfer or carrier foils.

4. Conductor foil (1), manufactured using the method according to claim 2, characterized in that it comprises an electrically conductive material and has zones with preworked interfacial connections (4, 4'), which project from the side (1') of the conductor foil (1).

5. Method for the manufacture of circuit boards with two or more electrically conductive, plated-through layers (1, 10) using the method according to claim 1 and employing a first conductor foil (1), which is plated zonally onto at least one side (1') and has a desired number of preworked interfacial connections (4, 4'), characterized in that another conductor foil (10), which has no preworked interfacial connections, is so applied by means of a connecting medium (5) to the first conductor foil (1) with the preworked interfacial connections (4, 4'), that the conductor foils are electrically connected via said preworked interfacial connections (4, 4') and the remaining zones are electrically insulated by the intermediate connecting medium, the preworked interfacial connections (4, 4') penetrating the connecting medium (5) on pressing together the conductor foils (1, 10), which at the intended points form the interfacial connections (15, 15').

6. Method for the manufacture of circuit boards according to claim 5, characterized in that in a photochemical process subsequently blind holes (7, 7') are exposed and developed in the conductor foils (1, 10), so that access is created to the flat boundary (6, 6') of the interfacial connections (15, 15'), that by sand blasting or plasma etching any adhesive residues present are removed from the boundaries (6, 6') of the interfacial connections (15, 15'), that chemically one or more metal coatings (8, 8') are applied in planned manner to the metal foil/plating interface (13) and that the subsequently created blind holes (7, 7') are filled by hot air tin coatings (9) or the pressing in of conductive solder pastes or conductive plastics or simply by melting on said blind holes (7, 7').

7. Method for the manufacture of circuit boards, according to one of the claims 5 or 6, characterized in that copper foils are used as conductor foils (1, 10).

8. Method for the manufacture of circuit boards according to one of the claims 5 to 7, characterized in that the method is performed in a continuous roll to roll processing of the metal coatings (1, 10) and non-metallic coatings (2, 5) to be processed by bringing together on a roll.

9. Circuit board with two or more electrically conductive, contacted-through coatings (1, 10) produced by using the method according to one of the claims 1 to 3 and 5 to 8, characterized in that the conductor foils (1, 10) are separated by an intermediate layer of an electrically non-conductive connecting medium (5), that at least one conductor foil (1) is zonally plated onto at least one side (1'), that the other conductor foil (10) is so applied to the conductor foil (1) with the preworked interfacial connections (4, 4') that the conductor foils (1, 10) are connected by means of said preworked interfacial connections (4, 4'), which penetrate the connecting medium coating (5), so that two conductor foils (1, 10) are electrically connected at intended points (15, 15').

## Revendications

1. Procédé de fabrication de feuilles conductrices (1, 10) reliées entre elles pour des cartes de circuits imprimés à deux ou plusieurs couches, dans lequel une première feuille conductrice (1) est plaquée par zones sur au moins une face (1') afin d'obtenir un nombre souhaité de zones métallisées (4, 4') réalisées préalablement, caractérisé en ce qu'une autre feuille conductrice (10), qui ne présente pas de zones métallisées (4, 4') réalisées préalablement, peut être appliquée à l'aide d'un moyen de liaison (5) sur la feuille conductrice (1) dotée des zones métallisées (4, 4') réalisées préalablement, de telle sorte qu'une connexion électrique soit établie entre les feuilles conductrices par les zones métallisées (4, 4') réalisées préalablement de la première feuille conductrice (1) et que le moyen de liaison (5) isole les zones comprises entre les zones métallisées (4, 4') réalisées préalablement.

2. Procédé de fabrication de feuilles conductrices (1, 10) reliées entre elles selon la revendication 1, dans lequel une couche de résine photosensible (2) est laminée sur la première feuille conductrice (1) et un motif librement défini d'évidements (3, 3') dans la couche photosensible (2) est exposé et développé par voie photochimique, caractérisé en ce que des zones métallisées (4, 4') réalisées préalablement sont plaquées dans les évidements (3, 3') des feuilles conductrices (1) de telle sorte que les zones métallisées (4, 4') réalisées préalablement remplissent entièrement les évidements (3, 3') et fassent saillie par-dessus la couche photosensible (2) en présentant des limites (11, 11') semi-circulaires ou elliptiques, de telle sorte que la surface de l'interface hétérogène entre la couche photosensible et le placage soit irrégulière.

3. Procédé de fabrication de feuilles conductrices (1, 10) reliées entre elles selon l'une ou l'ensemble des revendications 1 ou 2, caractérisé en ce que les feuilles de métal (1, 10) à travailler sont masquées par des feuilles de transfert ou de support.

4. Feuille conductrice (1) fabriquée en utilisant le procédé selon la revendication 2, caractérisée en ce qu'elle se compose d'un matériau conducteur électrique et présente des zones métallisées (4, 4') réalisées préalablement qui font saillie sur la face (1') de la feuille conductrice (1).

5. Procédé de fabrication de cartes de circuits imprimés à deux ou plusieurs couches conductrices (1, 10) mises en contact, utilisant le procédé selon la revendication 1, faisant appel à une première feuille conductrice (1) qui est plaquée par zones sur au moins une face (1') et présente un nombre souhaité de zones métallisées (4, 4') réalisées préalablement, caractérisé en ce qu'une autre feuille conductrice (10), qui ne présente pas de zones métallisées réalisées préalablement, est appliquée sur la feuille conductrice (1) dotée des zones métallisées (4, 4') réalisées préalablement à l'aide d'un moyen de liaison (5), de telle sorte qu'une connexion électrique soit établie entre les feuilles conductrices par les zones métallisées (4, 4') préparées sur celle-ci et que les zones restantes soient isolées par le moyen de liaison (5) situé entre elles, les zones métallisées (4, 4') réalisées préalablement pénétrant dans le moyen de liaison (5) lors de la compression des feuilles conductrices (1, 10) ensemble et les feuilles conductrices (1, 10) formant les placages (15, 15') aux endroits prévus.

6. Procédé de fabrication de cartes de circuits imprimés selon la revendication 5, caractérisé en ce que des trous borgnes (7, 7') sont ultérieurement exposés et évidés par développement dans les feuilles conductrices (1, 10) au cours d'un procédé photochimique, de façon à créer un accès aux limites planes (6, 6') des zones métallisées (15, 15'), en ce que les résidus d'adhésif sont enlevés par sablage ou attaque au plasma des limites (6, 6') des zones métallisées (15, 15'), en ce qu'une ou plusieurs couches métalliques (8, 8') sont sélectivement appliquées par voie chimique sur l'interface (13) entre les feuilles métalliques et les zones métallisées, et en ce que les trous bornes (7, 7') formés ultérieurement sont remplis par des points d'étamage à l'air chaud (9) ou par l'enfoncement de pâtes de brasage conductrices ou de plastique conducteur ou simplement par comblement par fusion de ces trous borgnes (7, 7').

7. Procédé de fabrication de cartes de circuits imprimés selon l'une ou l'ensemble des revendications 5 ou 6, caractérisé en ce que les feuilles conductrices (1, 10) utilisées sont des feuilles métalliques en cuivre.

8. Procédé de fabrication de cartes de circuits imprimés selon l'une ou l'ensemble des revendications 5 à 7, caractérisé en ce que le procédé est exécuté en continu dans un traitement de rouleau-à-rouleau des couches métalliques (1, 10) et des couches non métalliques (2, 5) à travailler, par assemblage sur un rouleau.

9. Carte de circuits imprimés à deux ou plusieurs couches (1, 10) conductrices mises en contact, utilisant le procédé selon l'une ou l'ensemble des revendications 1 à 3 et 5 à 8, caractérisée en ce que les feuilles conductrices (1, 10) sont séparées par une couche intermédiaire d'un moyen de liaison (5) non conducteur électrique, en ce qu'au moins une feuille conductrice (1) est plaquée par zones sur au moins une face (1'), en ce que l'autre feuille conductrice (10) est appliquée sur la feuille conductrice (1) dotée des zones métallisées (4, 4') réalisées préalablement de telle sorte que les feuilles conductrices (1, 10) soient reliées par ces zones métallisées (4, 4') réalisées préalablement, lesquelles zones métallisées (4, 4') réalisées préalablement pénètrent dans la couche de moyen de liaison (5), une liaison électrique étant ainsi établie entre deux feuilles conductrices (1, 10) aux endroits prévus (15, 15').
